Europäisches Patentamt

(19) European Patent Office

Office européen des brevets

(11) Publication number: **0 150 882**
**B1**

(12) EUROPEAN PATENT SPECIFICATION

(45) Date of publication of patent specification: **20.09.89**

(21) Application number: **85200069.4**

(22) Date of filing: **24.01.85**

(51) Int. Cl.⁴: **H 01 L 21/58, C 09 J 7/02**

(54) Conductive die attach tape.

(30) Priority: **30.01.84 US 574815**

(43) Date of publication of application:
**07.08.85 Bulletin 85/32**

(45) Publication of the grant of the patent:
**20.09.89 Bulletin 89/38**

(84) Designated Contracting States:
**BE CH DE FR GB IT LI NL**

(56) References cited:
**EP-A-0 032 728**
**DD-A- 158 076**
**US-A-3 912 569**

(73) Proprietor: **National Starch and Chemical
Corporation
10 Finderne Avenue Box 6500
Bridgewater New Jersey 08807 (US)**

(72) Inventor: **Aurichio, Joseph Anthony
Route 10, Nottingham Way
Anderson, SC 29621 (US)**

(74) Representative: **Smulders, Theodorus A.H.J., Ir.
et al
Vereenigde Octrooibureaux Nieuwe Parklaan
107
NL-2587 BP 's-Gravenhage (NL)**

Courier Press, Leamington Spa, England.

## Description

### Background of the Invention

Silicon wafers with multiple printed circuitry are diced (or sawed) into individual circuits (chips) by first placing the wafer onto a dicing film (a polymeric support film having a tacky surface) which holds the wafer in place during the dicing operation. The wafer is then partially cut through its thickness by the dicing implement (e.g., a diamond-impregnated wheel). The wafer is then cracked into individual chips and separated by stretching the support film. The chips are then picked up individually by a vacuum chuck to be placed onto the chip carrier (previously treated with adhesive to hold the chip). The adhesive is then cured to secure the chip into place and provide a ground for the chip during the step in which wires are bonded to the chip. There are a number of current methods of application of the adhesive to the chip carrier (e.g., use of syringe, use of stamp pad, use of other dispensing technique). Most methods cannot offer uniform adhesive thickness, and some are cumbersome and time consuming in application.

### Summary of the Present Invention

The present invention is directed to a tape product which would provide the desired degree of adhesive uniformity in terms of thickness and area of coverage to the chip. It comprises a support tape with a pattern of adhesive of a size and shape to support at least one semiconductor chip thereon. The individual chips would be each positioned over a corresponding adhesive support and contacted therewith. After contact between chip and support film/adhesive has been made, the chip is removed from the film with its adherent adhesive support attached. This chip/adhesive composite can then be placed into a suitable chip carrier and cured in an appropriate fashion. Afterwards, wires can be bonded to the chip as conventionally performed.

### Description of the Drawings

The Drawings which form a portion of the present specification are descriptive of certain embodiments of the present invention wherein:

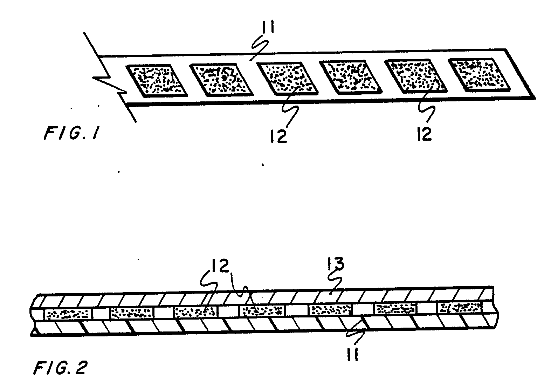

Fig. 1 is a perspective view of the conductive die attach tape of the present invention; and

Fig. 2 is a cross-sectional view of a preferred embodiment of the invention wherein a release liner (or cover sheet) is affixed over the adhesive to protect it from contamination by foreign matter.

### Detailed Description of the Present Invention

The present invention relates to a conductive die attach tape useful in releasably supporting semiconductor chips on a conductive adhesive which comprises: (a) a support film made of paper, polyethylene, polypropylene or polyester; and (b) a pattern of conductive adhesive releasably affixed to one side of the support film, the adhesive pattern being of a size and shape to support at least one semiconductor chip thereon.

The present invention also relates to a method of mounting a semiconductor chip in a chip carrier which comprises bonding the chip to the tape product of the invention, thereafter removing the chip and adherent conductive adhesive from the support film, and bonding the chip and adherent conductive adhesive to a chip carrier.

It is observed that a similar conductive die attach tape and method of mounting a semiconductor chip in a chip carrier are described in the earlier European patent application EP-A-0 135 416 which was published on 27 March 1985, i.e. after the filing date of the present application.

The present invention is new because the support film of the claimed conductive die attach tape is made of paper, polyethylene, polypropylene or polyester, whereas said earlier European patent application defines the support film as being made of polyolefin or polyvinylchloride.

The die attach tape of the present invention comprises a support film 11 with a suitable pattern of adhesive 12 and, in a preferred embodiment, a release liner 13 to protect the adhesive from contamination from foreign matter (e.g., dirt, dust, etc.). The adhesive 12 needs to release from the support film 11 when the chip/adhesive combination is removed therefrom. Therefore, it is generally desired that a suitable release layer be placed on the support film 11 to lie between it and the adhesive 12.

Representative support films 11 which can be used in the product of the present invention include paper as well as those made from such well known thermoplastic polymers as polyethylene, polypropylene and polyester. The thickness of the support film can range from about 12 to 250 μm, with a thickness of about 50 to about 125 μm being preferred.

Coated on one side of the support film, in a preferred embodiment, is a suitable release layer which, as will be mentioned below, allows for easy separation of the conductive adhesive/chip combination from the support film 11 prior to placement in the chip carrier. Representative release layers can comprise silicone and fluorocarbon compositions such as those described in the prior art (e.g., in U.S. Patent Nos. 3,912,569 and 3,575,917 to A. M. Kapral). These release layers need only be thick enough to confer the desired release properties (e.g., from about 0.23 to about 0.91 kg. per ream). If the surface of the support film has an inherent release layer function (polyfluorocarbon), the inherent release characteristics of its surface can be utilized in accordance with the present invention as the "release layer". A commercial source of suitable silicone release coated polymeric film (e.g., polypropylene with SILOX brand release coating) is Akrosil Corporation of Menasha, Wisconsin.

It is also possible to dispense with the release layer if polymers having a release feature upon heating are used. For example, a polypropylene film 11 can be heated (e.g., for 0.25-3 minutes at 45°C.-70°C.) after the chip and adhesive are bonded to one another to insure later clean release of the chip/adhesive composite.

Attached to the exposed surface of the release layer (or the film 11, if no release layer is used) is a suitable pattern of conductive adhesive 12 to form a point of attachment for the semiconductor chips that are to be later transferred to a chip carrier. Generally, the conductive adhesive pattern can comprise a series of square adhesive patterns of a suitable size and a suitable shape to approximate the area of the chip to be mounted thereon. The thickness of the adhesive can range from about 5 µm to about 75 µm. Suitable conductive adhesive compositions which can be utilized include those adhesive materials which are loaded with fillers to effect conductivity requirements (e.g., 2% to about 90%, by weight of a suitable conductive material). Representative conductive materials include finely divided conductive metals (e.g., aluminum, copper, silver, gold, palladium), or carbon black. Representative adhesive materials which can form a matrix for the conductive materials include polyimide, acrylic, epoxy, silicones, and various modified polymeric materials to meet desired thermal and conductivity requirements. One suitable adhesive is a silver filled polyimide (P-1011 brand from Epoxy Technology, Inc.).

In a preferred embodiment, the film product of the present invention also includes a suitable release liner 13 over the exposed surface of the adhesive to protect it from contamination and/or damage (e.g., inadvertent destruction of the preferred, substantially flat upper surface). For example, release coated paper can be employed as the release liner material. The release liner can have a differing release characteristic than the release layer if a release layer is used on the support film 11.

The film of the present invention can be formed using conventional lamination and printing operations. The release layer can, for example, be coated onto the support film by using conventional coating techniques followed by drying of the layer. The pattern of conductive adhesive is then applied to the dried release layer surface by appropriate printing procedures, e.g., screen printing or stamping processes, and then the adhesive is transferred to the support film 12 by lamination. If a release liner is desired over the exposed surface of the adhesive, it can also be applied by conventional lamination procedures.

## Claims

1. A conductive die attach tape useful in releasably supporting semiconductor chips on a conductive adhesive which comprises:
   (a) a support film made of paper, polyethylene, polypropylene or polyester, and
   (b) a pattern of conductive adhesive releasably affixed to one side of the support film, the adhesive pattern being of a size and shape to support at least one semiconductor chip thereon.
2. A tape as claimed in claim 1 wherein the support film is polyethylene.

3. A tape as claimed in claim 1 or 2 wherein the support film has a thickness of from about 12 µm to about 250 µm.

4. A tape as claimed in any of claims 1-3, which further comprises a release layer on the film between it and the adhesive.

5. A tape as claimed in claim 4 wherein the release layer comprises a silicone composition.

6. A tape as claimed in claim 4 wherein the release layer comprises a fluorocarbon composition.

7. A tape as claimed in any of claims 1-6 wherein the conductive adhesive has a thickness of from about 5 µm to about 75 µm.

8. A tape as claimed in any of claims 1-7 wherein the conductive adhesive contains a conductive metal in an adhesive material serving as a matrix for said conductive metal.

9. A tape as claimed in any of claims 1-8 which also has a release liner over the pattern of conductive adhesive.

10. A tape as claimed in any of claims 1-8 which releasably supports a semiconductor chip.

11. A method of mounting a semiconductor chip in a chip carrier which comprises bonding the chip to the tape of any of claims 1-8, thereafter removing the chip and adherent conductive adhesive from the support film, and bonding the chip and adherent conductive adhesive to a chip carrier.

## Patentansprüche

1. Leitendes Band zur Befestigung von Chips, das geeignet ist, Halbleiterchips abtrennbar auf einem leitenden Klebstoff zu halten, das umfaßt:
   (a) einen aus Papier, Polyethylen, Polypropylen oder Polyester hergestellten Trägerfilm und
   (b) ein Muster eines leitenden Klebstoffes, das abtrennbar auf einer Seite des Trägerfilmes befestigt ist, wobei das Klebstoffmuster eine solche Größe und Form hat, um mindestens einen Halbleiterchip darauf zu halten.
2. Band nach Anspruch 1, worin der Trägerfilm Polyethylen ist.
3. Band nach Anspruch 1 oder 2, worin der Trägerfilm eine Dicke von etwa 12 µm bis 250 µm hat.
4. Band nach irgendeinem der Ansprüche 1 bis 3, das weiterhin eine Trennschicht zwischen dem Film und dem Klebstoff umfaßt.
5. Band nach Anspruch 4, worin die Trennschicht eine Siliconzusammensetzung umfaßt.
6. Band nach Anspruch 4, worin die Trennschicht eine Fluorkohlenstoffzusammensetzung umfaßt.
7. Band nach irgendeinem der Ansprüche 1 bis 6, worin der leitende Klebstoff eine Dicke von etwa 5 µm bis 75 µm aufweist.
8. Band nach irgendeinem der Ansprüche 1 bis 7, worin der leitende Klebstoff ein leitendes Metall in einem Klebstoffmaterial enthält, das als Matrix für das leitende Metall dient.
9. Band nach irgendeinem der Ansprüche 1 bis 8, das über dem Muster des leitenden Klebstoffes noch eine Trenneinlage aufweist.

10. Band nach irgendeinem der Ansprüche 1 bis 8, das in abtrennbarer Weise einen Halbleiterchip trägt.

11. Verfahren zum Befestigen eines Halbleiterchips an einem Chipträger, das das Verbinden des Chips mit dem Band gemäß irgendeinem der Ansprüche 1 bis 8, das anschließende Entfernen des Chips und des daran haftenden, leitenden Klebstoffes vom Trägerfilm und das Befestigen des Chips und des daran haftenden leitenden Klebstoffes an einem Chipträger umfaßt.

**Revendications**

1. Un ruban conducteur de montage de puce utile pour supporter de manière amovible des puces de semi-conducteur sur un adhésif conducteur qui comprend:

(a) un film support fabriqué en papier, polyéthylène, polypropylène ou polyester, et

(b) une configuration d'adhésif conducteur fixée de manière amovible sur une face du film support, la configuration de l'adhésif étant d'une dimension et d'une forme permettant d'y supporter au moins une puce de semi-conducteur.

2. Un ruban comme revendiqué à la revendication 1, dans lequel le film support est un polyéthylène.

3. Un ruban comme revendiqué à l'une des revendications 1 ou 2, dans lequel le film support a une épaisseur comprise entre environ 12 et environ 250 µm.

4. Un ruban comme revendiqué dans l'une quelconque des revendications 1 à 3, qui comprend encore une couche de dégagement sur le film entre le film et l'adhésif.

5. Un ruban comme revendiqué à la revendication 4, dans lequel la couche de dégagement est constituée d'une composition au silicone.

6. Un ruban comme revendiqué à la revendication 1 et à la revendication 4, dans lequel la couche de dégagement est constituée d'une composition au fluorocarbone.

7. Un ruban comme revendiqué dans l'une quelconque des revendications 1 à 6, dans lequel l'adhésif conducteur a une épaisseur comprise entre environ 5 et environ 75 µm.

8. Un ruban comme revendiqué dans l'une quelconque des revendications 1 à 7, dans lequel l'adhésif conducteur contient un métal conducteur dans un matériau adhésif servant de matrice pour ledit métal conducteur.

9. Un ruban comme revendiqué dans l'une quelconque des revendications 1 à 8, qui comporte aussi une garniture de dégagement sur la configuration d'adhésif conducteur.

10. Un ruban comme revendiqué dans l'une quelconque des revendications 1 à 8, qui supporte de manière amovible une puce de semi-conducteur.

11. Un procédé de montage d'une puce d'un semi-conducteur sur un support de puce qui comprend la fixation de la puce sur le ruban de l'une quelconque des revendications 1 à 8, ensuite le dégagement de la puce avec l'adhésif conducteur adhérant par rapport au film support, et la fixation de la puce et de l'adhésif conducteur adhérant sur un support de puce.

11

FIG. 1

12          12

12          13

11

FIG. 2

1